# DEMANDE DE BREVET EUROPEEN

(11) **EP 1 486 582 A1**
(43) Date de publication de la demande: **15.12.2004**
(21) Numéro de dépôt: 03013514.9
(22) Date de dépôt: 13.06.2003
(51) Int. Cl.: C23C 14/06, C23C 16/30, C23C 14/32

(54) **Pièce de micro-mécanique à frottement réduit**

(71) Demandeur: ASULAB S.A., 2074 Marin (CH)
(72) Inventeur: Dinger, Rudolf, 2024 Saint-Aubin (CH); Born Jean-Jacques, CH-1110 Morges (CH); Randin Jean-Paul, 2016 Cortaillod (CH)
(74) Mandataire: Thérond, Gérard Raymond

(57) **Abrégé**

Les zones de frottement sont revêtues d'un revêtement antifriction constitué par un film de chalcogénure métallique tel que MoS₂ à structure fullerènes ou nanotubes, ledit film étant obtenu par déposition à l'arc avec une pression gazeuse plus élevée au niveau de la cathode.

## Description

La présente invention concerne des pièces de micro-mécanique formant la chaîne cinématique d'un mécanisme dont la précision du fonctionnement est d'autant plus grande que le coefficient de frottement entre les pièces est réduit et que ledit coefficient est stable dans le temps. L'invention s'applique plus particulièrement à un mouvement horloger qui comporte des pièces entraînées en rotation, en oscillations, ou en translation.

Les pièces de micro-mécanique sont généralement fabriquées à partir d'un matériau métallique, tel que le fer ou des alliages, le cuivre, le laiton ou autres, par des techniques connues dans ce domaine, telles que le décolletage ou l'étampage.

Même si les surfaces en contact dans la chaîne cinématique font l'objet d'une finition par polissage, il est indispensable de prévoir une lubrification des paliers, des zones à chocs, ou de contacts glissants. Cette lubrification est encore le plus souvent effectuée au moyen d'huiles classiques ou synthétiques, ou de graisses, dont les compositions sont optimisées en fonction des pièces particulières en mouvement, de leur état de surface et de leur mouillabilité. De tels lubrifiants liquides ou pâteux ne sont pas totalement satisfaisants en ce que leurs propriétés s'altèrent généralement au cours du temps en fonction des conditions externes, telles que l'humidité ou la pression partielle en oxygène, et en ce que leur application et leur maintien en place reste un problème délicat.

Pour pallier les inconvénients ci-dessus on a cherché à remplacer les lubrifiants liquides ou pâteux par des lubrifiants solides, c'est-à-dire des revêtements autolubrifiants. A cet effet, on s'est naturellement orienté vers l'utilisation de chalcogenures métalliques, tels que le bisulfure de molybdène, antérieurement utilisé comme adjuvant dans les huiles ou les graisses.

Le brevet US 4,324,803 fait appel à un procédé de pulvérisation cathodique permettant de déposer sur un substrat une couche autolubrifiante d'un chalcogénure métallique permettant d'abaisser le coefficient de frottement à une valeur comprise entre 0,03 et 0,04 pour une épaisseur de l'ordre de 1 µm. Ce revêtement est dit de type "turbostratique", ce qui signifie, selon les inventeurs, que la couche de chalcogénure est essentiellement lamellaire, mais avec un degré d'ordre plus grand que dans le graphite.

D'après un document postérieur, le brevet CH 642 509, un tel dépôt autolubrifiant présente l'inconvénient d'être sensible à une atmosphère humide et oxydante, ce qui provoque une détérioration des propriétés pour lesquelles il était prévu. Pour remédier à cet inconvénient le brevet précité propose d'effectuer par pulvérisation cathodique un revêtement composite de MoS₂ sous forme lamellaire et d'un polymère solide hydrophobe, tel que le polyéthylène téréphtalate (PTFE). Ce procédé a certainement un effet bénéfique sur le vieillissement du revêtement, mais probablement un effet négatif sur le coefficient de frottement, même si cela ne ressort pas clairement de la description.

Pour réduire l'usure des pièces et améliorer leurs propriétés tribologiques, il a également été proposé de revêtir leurs parties en contact d'un film polycristallin de diamant comme cela est décrit par exemple dans le brevet US 5,242,711. Les divers procédés utilisés pour effectuer ce revêtement visent essentiellement à résoudre un problème d'accrochage sur le substrat, le coefficient de frottement ayant par ailleurs une valeur moyenne se situant autour de 0,1 c'est-à-dire une valeur du même ordre que les huiles citées au début.

L'invention a donc pour objet de pallier les inconvénients précités en procurant des pièces de micro-mécanique dont les parties en contact sont revêtues d'un lubrifiant solide ayant un très faible coefficient de frottement, dont la valeur se maintient sur une longue période, quelles que soient les conditions extérieures, ledit revêtement réduisant également l'usure due au frottement.

A cet effet, l'invention a pour objet des pièces de micro-mécanique incorporées dans la chaîne cinématique d'un mécanisme et dont les zones de frottement ont un revêtement anti-friction. Le revêtement est caractérisé en ce qu'il est formé par le dépôt d'un chalcogénure métallique nanoparticulaire obtenu avec une structure de type fullerènes ou nanotubes à très faible coefficient de frottement.

Typiquement, le coefficient de frottement est compris entre 0,05 et 0,01, valeurs beaucoup plus faibles que celles obtenues avec des huiles ou des graisses connues antérieurement.

Les métaux susceptibles de former des chacolégures, c'est-à-dire des sulfures, séléniures et tellurures, à structure de type fullerènes ou nanotubes peuvent être choisis parmi Ga, In, Sn et les métaux de transition Mo, W, V, Zr, Hf, Pt, Re, Nb, Ta, Ti, Cr et Ru. Parmi tous ces chalcogénures ont retiendra particulièrement ceux qui sont déjà connus sous forme fullerènes et dont les propriétés tribologiques ont été avérées, à savoir le bisulfure ou le biséléniure de molybdène (MoS₂, MoSe₂) le sulfure de plomb (PbS), le bisulfure de tungstène (WS₂) et le biséléniure de niobium (NbS₂).

De telles pièces de micro-mécaniques, dans lesquelles ni le vieillissement du lubrifiant, ni l'usure n'affectent la régularité du fonctionnement, sont plus particulièrement les pièces d'un mouvement d'horlogerie.

Selon un autre aspect de l'invention, notamment lorsqu'il s'agit d'un mouvement d'horlogerie de type dit "squelette", pour préserver l'aspect esthétique des parties visibles en mouvement (rouages, balancier, etc.) les zones de frottement sur lesquelles doit être déposé le revêtement antifriction sont délimitées, soit par l'application d'un enduit, soit par un masque empêchant l'accrochage de la couche de chalcogénure sous forme fullerènes ou nanotubes.

Le substrat formant la pièce, et notamment une pièce d'horlogerie peut être en métal ou alliage métallique. Les pièces peuvent également être réalisées à partir de matériaux non métalliques, par exemple par découpage d'une plaquette de silicium, ou par formage d'une pierre synthétique tel que le rubis. Dans un mouvement horloger les pièces concernées par l'application localisée du revêtement antifriction sont, de façon non limitative les palette d'ancre et les dents de la roue d'échappement, les organes régulateurs, tel que l'axe de pivotement du balancier, les paliers des rouages de transmission, le mécanisme de la tige de remontoir, la cage et le ressort de barillet. Dans la plupart des cas il est suffisant d'appliquer le revêtement antifriction sur une seule des deux surfaces en frottement. Toutefois, compte-tenu de l'excellente adhésion du film de chalcogénure sous forme fullerènes ou nanotubes, il est également possible de traiter les deux surfaces.

Pour former le revêtement de chalcogénures sous forme fullerène ou nanotubes, le procédé consiste à adapter la technologie de dépôt à l'arc avec une pression gazeuse élevée localisée, telle que décrite par exemple par Bilek M.M.M et al [J. Appl. Phys. 83, 2965-2970 (1998)] en prenant pour cible un chalcogénure, par exemple MoS₂. A cet effet, dans une enceinte, dont le vide est entretenu en permanence par pompage, contenant la cible de MoS₂ on place à une distancé d'environ 20cm la pièce à traiter préalablement polie miroir, en délimitant, si nécessaire, les zones devant recevoir le revêtement. Un revêtement de chalcogénures étant généralement noir, il peut être souhaitable, par exemple pour des raisons esthétiques en horlogerie, de traiter uniquement les surfaces en contact qui ne sont généralement plus visibles une fois les pièces assemblées. Ce résultat peut être obtenu en empêchant l'accrochage du revêtement par exemple en appliquant un vernis, ou en effectuant à travers un masque approprié un dépôt de photoresist qui sera ultérieurement éliminé.

La pression gazeuse élevée localisée est obtenue en introduisant à travers un trou de petit diamètre pratiqué dans la cible MoS₂ un flux gazeux, par exemple de l'azote. On peut alors avoir, entre le voisinage de l'anode (pièce) et le voisinage de la cathode (cible MoS₂), un rapport de pression compris entre 1/500 et 1/5000. La pression gazeuse au voisinage de la cathode est par exemple comprise entre 1 et 50 Torr, et au voisinage de l'anode entre 0,1 et 10 Torr. Pendant l'opération de dépôt, la pièce est maintenue à une température relativement basse, par exemple comprise entre 50°C et 200°C, ce qui permet d'éviter toute dégradation thermique du vernis ou du masque dans le cas où la pièce en comporterait.

Le coefficient de frottement, mesuré selon les méthodologies de Suzuki et al. [Wear 218, 110-118 (1998)] est compris entre 0,05 et 0,01, valeurs très inférieures à celles mesurées pour des chalcogénures non fullerènes.

## Revendications

1. Pièce de micro-mécanique comportant un substrat de forme ayant des zones de frottement dans une liaison cinématique avec d'autres pièces d'un mécanisme, **caractérisée en ce que** les zones de frottement comporte un revêtement antifriction constitué par un chalcogénure métallique nanoparticulaire à structure fullerènes ou nanotubes procurant un très faible coefficient de frottement.

2. Pièce de micro-mécanique selon la revendication 1, **caractérisée en ce que** le coefficient de frottement est compris entre 0,05 et 0,01.

3. Pièce de micro-mécanique selon la revendication 1, **caractérisée en ce que** le chalcogénure métallique est choisi parmi le bisulfure ou biséléniure de molybdène (MoS₂; MoSe₂), le sulfure de plomb (PbS), le bisulfure de tungstène (WS₂) et le biseleniure de nobium (NbSe₂).

4. Pièce de micro-mécanique selon la revendication 1, **caractérisée en ce que** le substrat de forme est une pièce d'un mouvement horloger.

5. Pièce de micro-mécanique selon la revendication 4, **caractérisée en ce que** les pièces sont en outre revêtues d'un enduit délimitant les zones de frottement sur lesquelles est appliquée le revêtement anti-friction en préservant l'aspect esthétique des parties non revêtues dudit revêtement anti-friction.

6. Pièce de micro-mécanique selon la revendication 4, **caractérisée en ce qu'**un masque est placé sur le substrat de forme pour préserver l'aspect esthétique des parties de pièces situées en dehors des zones de frottement.

7. Pièce de micro-mécanique selon la revendication 1, **caractérisée en ce que** le substrat de forme est réalisé en métal ou en un alliage métallique.

8. Pièce de micro-mécanique selon la revendication 1, **caractérisée en ce que** le substrat de forme est réalisé en silicium ou en pierre synthétique.

9. Procédé de fabrication d'une pièce de micro-mécanique comportant un substrat de forme ayant des zones de frottement dans une liaison cinématique avec d'autres pièces d'un mécanisme, **caractérisé en ce qu'**on soumet le substrat à un arc électrique formé entre ledit substrat constituant l'anode maintenue à une température relativement basse, et une pastille de chalcogénure métallique constituant la cathode en maintenant à sa surface une pression gazeuse beaucoup plus grande que la pression gazeuse à la surface de l'anode, ledit chalcogénure étant précurseur d'un dépôt de structure de type fullerènes ou nanotubes sur ledit substrat.

10. Procédé selon la revendication 9, **caractérisé en ce que** le rapport de pression entre l'anode et la cathode est compris entre 1/500 et 1/5000.

11. Procédé selon la revendication 9, **caractérisé en ce que** la température de l'anode est maintenue à une température comprise entre 50°C et 200°C selon la nature de substrat.

12. Procédé selon la revendication 9, **caractérisé en ce que** le gaz utilisé pour ajuster les pressions gazeuses au voisinage de l'anode et au voisinage de la cathode est de l'azote.

13. Procédé selon la revendication 9, **caractérisé en ce que** les zones de frottement sont délimitées par des produits empêchant l'accrochage de chalcogénures métallique sous forme fullerène ou métallique.
